# EUROPÄISCHE PATENTSCHRIFT

(11) **EP 1 493 229 B1**
(45) Veröffentlichungstag und Bekanntmachung des Hinweises auf die Patenterteilung: **27.06.2007**
(21) Anmeldenummer: 03720341.1
(22) Anmeldetag: 20.03.2003
(51) Int. Cl.: H03K 17/082

(54) **SCHALTUNGSANORDNUNG ZUM ANSTEUERN EINES HALBLEITERSCHALTERS**
CIRCUIT ARRANGEMENT FOR CONTROL OF A SEMICONDUCTOR CIRCUIT
CIRCUIT SERVANT A COMMANDER UN COMMUTATEUR A SEMI-CONDUCTEUR

(30) Priorität: 08.04.2002 DE 10215363
(43) Veröffentlichungstag der Anmeldung: 05.01.2005
(73) Patentinhaber: Infineon Technologies AG, 81669 München (DE)
(72) Erfinder: HORNKAMP, Michael, 59469 Waltringen (DE)
(74) Vertreter: Patentanwälte Westphal, Mussgnug & Partner
(86) Internationale Anmeldenummer: PCT/EP2003/002938
(87) Internationale Veröffentlichungsnummer: WO 2003/085832

(56) Entgegenhaltungen:
- EP-A- 0 902 537
- US-A- 4 540 893
- US-A- 5 946 178
- KURATLI C ET AL: "IMPLEMENTATION OF HIGH PEAK-CURRENT IGBT GATE DRIVE CIRCUITS IN VLSI COMPATIBLE BICMOS TECHNOLOGY" IEEE JOURNAL OF SOLID-STATE CIRCUITS, IEEE INC. NEW YORK, US, Bd. 31, Nr. 7, 1. Juli 1996 (1996-07-01), Seiten 924-932, XP000632377 ISSN: 0018-9200

## Beschreibung

Die Erfindung betrifft eine Schaltungsanordnung zum Ansteuern eines Halbleiterkörpers.

Mit immer schneller schaltenden Halbleiterschaltern wie beispielsweise IGBT-Modulen (IGBT = Insuluted Gate Bipolar Transistor) und immer höheren Strömen wird es auch immer schwieriger, Abschaltspannungen auf einen zulässigen Bereich zu begrenzen. Beim Überschreiten der zulässigen Spannung über der gesteuerten Strecke eines Halbleiterschalters kommt es zu dessen Zerstörung, was auf alle Fälle verhindert werden soll. Besonders kritisch ist dabei der Fall eines Kurzschlusses, da dabei eine größere Stromänderungssteilheit di/dt auftritt. Die Stromänderungssteilheit di/dt induziert in den Streuinduktivitäten eine Spannung, die sich zur ohnehin anliegenden Spannung addiert. Dabei können ohne weiteres die zulässigen Spannungen insbesondere über der gesteuerten Strecke des Halbleiterschalters überschritten werden.

Ein theoretisch einfacher Weg besteht darin, die Streuinduktivitäten zu verringern. In der Praxis ist dies jedoch nur schwer bis gar nicht möglich. Eine in der Praxis häufig angewandte Methode besteht in der Verwendung von Zener-Dioden in Schutzschaltungen, die als "Aktive Clamping" bekannt sind. Diese Methode beruht darauf, dass der Halbleiterschalter im Abschaltvorgang verlangsamt wird. Eine derartige Anordnung ist beispielsweise in der DE 44 28 675 A1 beschrieben und umfasst eine oder mehrere Zener-Dioden, die beispielsweise zwischen Gate und Kollektor eines IGBTs geschaltet sind. Bei zahlreichen Anwendungen führt diese Anordnung jedoch zu hohen Verlustleistungen in den Zener-Dioden und zu thermischen Problemen.

Aufgabe der Erfindung ist es daher, eine Schaltungsanordnung der eingangs genannten Art anzugeben, die diese Nachteile nicht aufweist.

Aus der US 5,946,178 A ist eine Halbleiteranordnung mit Überspannungsschutz bekannt. Die Anordnung weist einen Halbleiterschalter auf, der mittels eines durch eine Treiberstufe verstärkten Steuersignals angesteuert wird. Der Überspannungsschutz ist zwischen einerseits dem Kollektor und andererseits dem Gateanschluss oder dem Kollektor des Leistungsschalters angeschlossen.

Der Überspannungsschutz umfasst einen Kondensator, an den eine Spannungsüberwachung angeschlossen ist, welche den Spannungspegel bestimmt, auf den der Kondensator nach Aktivierung des Überspannungsschutzes entladen wird.

Aus Kuratli C. et al.: "Implementation of High Peak-Current IGBT Gate Drive Circuits in VLSI compatible BiCMOS Technology", IEEE Journal of Solid-State Circuits, IEEE Inc. New York, US, Bd. 31, Nr. 7, 1. Juli 1996 (1996-07-01), Seiten 924-932, ist eine Schaltungsanordnung zur Begrenzung einer sich zeitlich schnell ändernden, über der Laststrecke eine IGBTs abfallenden Spannung bekannt. Hierzu wird der Strom eines mit dem Kollektor des IGBTs verbundenen Kondensators mittels eines programmierbaren Stromspiegels sowie mittels eines dem Stromspiegel nachgeschalteten Treibers verstärkt, bevor er dem Gate des IGBT zugeführt wird. Zusätzlich verstärkt der nachgeschaltete Treiber auch den Strom einer eingangsseitigen Treiberstufe.

Die der Erfindung zugrunde liegende Aufgabe wird gelöst durch eine Schaltungsanordnung gemäß Patentanspruch 1. Ausgestaltungen und Weiterbildungen des Erfindungsgedankens sind Gegenstand von Unteransprüchen.

Im einzelnen wird die Aufgabe durch eine Schaltungsanordnung zum Ansteuern eines eine gesteuerte Strecke und einen Steueranschluss aufweisenden Halbleiterschalters gelöst, die einen Eingang, an den ein Schaltsignal zur Steuerung des Halbleiterschalters angelegt ist, und einen Ausgang, an den der Steueranschluss des Halbleiterschalters angeschlossen ist, aufweist. Zwischen Eingang und Ausgang ist eine Ansteuerschaltung geschaltet, bei der das Schaltsignal durch ein Haltesignal auf dem augenblicklichen Wert gehalten werden kann, wobei eine Auswerteschaltung eine der Spannung über der gesteuerten Strecke entsprechende Messspannung abgreift und für eine bestimmte Zeitspanne das Haltesignal für die Ansteuerschaltung erzeugt, wenn die Spannung über der gesteuerten Strecke des Halbleiterschalters einen ein Abschalten des Halbleiterschalters signalisierenden Anstieg aufweist.
Das Ende der bestimmten Zeitspanne kann dabei durch das Erreichen einer bestimmten Spannung über der gesteuerten Strecke des Halbleiterschalters, insbesondere eine vorgegebene Maximalspannung, bestimmt sein. Bevorzugt erfolgt nach dem Erreichen dieser Spannung aber kein abruptes Ändern der Schaltspannung, sondern eine langsame Änderung.

Somit ist es bei der Erfindung vorteilhafterweise also möglich, durch Einstellen kleiner Stromänderungssteilheiten di/dt Überspannungen beim Schalten zu vermeiden. Zu Beginn des Ausschaltens ändert sich das Schaltsignal beispielsweise mit fallender Flanke, worauf die Spannung über der gesteuerten Strecke des Halbleiterschalters ansteigt. Die Auswerteschaltung registriert einen Spannungsanstieg über der gesteuerten Strecke des Halbleiterschalters sobald der Halbleiterschalter zu sperren beginnt. Zu diesem Zeitpunkt wird der momentane Wert des Schaltsignals für eine bestimmte Zeitspanne so "eingefroren", dass der Halbleiterschalter seinen Spannungsanstieg zwar fortsetzt, das Schaltsignal dabei aber konstant bleibt. Erst wenn sich die Spannung über dem der gesteuerten Strecke des Halbleiterschalters vollständig aufgebaut hat, wird die Schaltspannung langsam abgesenkt.

Bei der Erfindung wird die Auswerteschaltung erst ab einer bestimmten Mindestspannung über der Laststrecke des Halbleiterschalters aktiviert. Somit wird die Stromänderungssteilheit di/dt erst ab einem bestimmten Wert der Spannung über der gesteuerten Strecke des Halbleiterschalters begrenzt, so dass beispielsweise im Normalbetrieb keine Begrenzung erfolgt, während in Ausnahmefällen bei höheren Spannungen die zu steuernde Strecke beeinflusst wird.

Bei der Erfindung ist vorgesehen, dass die Auswerteschaltung die Spannung zwischen einem Anschluss der gesteuerten Strecke und dem Steueranschluss des Halbleiterschalters zur Bestimmung der Spannung über der gesteuerten Strecke des Halbleiterschalters auswertet. Auf diese Weise ist eine besonders aufwandsarme Bestimmung der Spannung über der gesteuerten Strecke möglich. Beispielsweise bei IGBTs (IGBTs = Insulated Gate Bipolar Transistor) ist es somit möglich die Gate-Kollektor-Spannung auszuwerten als Maß für die zwischen Emitter und Kollektor auftretende Spannung.

Darüber hinaus ist die erfindungsgemäße Schaltungsanordnung insbesondere zur Ansteuerung von IGBTs geeignet, wobei auch andere Halbleiterschalter wie beispielsweise MOS-Feldeffekttransistoren, SiC-Feldeffekttransistoren, Bipolartransistoren etc. angesteuert werden können. Insbesondere IGBTs weisen beim Ausschalten in der fallenden Flanke der Gate-Emitter-Spannung ein sogenanntes Miller-Plateau auf, also einen Bereich, in dem die Gate-Emitter-Spannung für eine kurze Zeitdauer nicht weiter abfällt. In diesem Bereich beginnt der Halbleiterschalter auch zu sperren. Vorteilhafterweise wird nun bei Anwendung der Erfindung bei einem IGBT oder einem Halbleiterschalter mit ähnlichem Verhalten erfindungsgemäß der Miller-Bereich des Halbleiterschalters detektiert und für die bestimmte Zeitspanne gehalten.

Weiterhin ist vorgesehen, dass die Ansteuerschaltung zwei über einen Widerstand hintereinandergeschaltete Treiberstufen aufweist, wobei das Haltesignal am Eingang der ausgangsseitigen Treiberstufe eingespeist wird.

Dabei ist zur Einspeisung des Haltesignals ein Regeltransistor vorgesehen, dessen gesteuerte Strecke zwischen ein erstes Versorgungspotential und den Eingang der ausgangsseitigen Treiberstufe geschaltet ist und dessen Steueranschluss in Abhängigkeit von der Messspannung angesteuert wird derart, dass bei einem von der ersten Treiberstufe erzeugten Signal zum Durchsteuern des Halbleiterschalters das Haltesignal erzeugt wird, das diesem Signal entgegenwirkt und damit dessen Anstieg abflacht.

Der Steueranschluss des Regeltransistors ist über ein Koppelnetzwerk mit einem Anschluss der Laststrecke des Halbleiterschalters gekoppelt. Das Koppelnetzwerk seinerseits weist bevorzugt ein Kondensator-Widerstands-Glied (RC-Glied) auf.

Der Widerstand des Kondensator-Widerstands-Glieds wird dabei durch einen Widerstand gebildet, der zwischen den Steueranschluss des Regeltransistors und den Eingang der ausgangsseitigen Treiberstufe geschaltet ist. Der Kondensator ist hierbei zwischen den Steueranschluss des Regeltransistors und den einen Anschluss der Laststrecke des Halbleiterschalters geschaltet. Der besagte Anschluss der Laststrecke kann beispielsweise bei einem IGBT durch dessen Kollektor gegeben sein.

Schließlich weist das Koppelnetzwerk eine Reihenschaltung zweier Dioden auf, wobei die Reihenschaltung der Dioden zwischen den Steueranschluss des Regeltransistors und ein zweites Versorgungspotential geschaltet ist und der Abgriff mit dem einen Anschluss der geregelten Strecke des Halbleiterschalters gekoppelt ist.

Vorzugsweise ist die Abklingzeitkonstante für das Haltesignal und damit für das Schaltsignal einstellbar, sodass die maximale Stromanstiegssteilheit frei einstellbar ist und ggf. an unterschiedliche Halbleiterschaltertypen anpassbar ist.

Die Erfindung wird nachfolgend anhand der in den Figurenzeichnungen dargestellten Ausführungsbeispiele näher erläutert. Es zeigt:
- Figur 1: ein erstes, allgemeines Ausführungsbeispiel einer erfindungsgemäßen Schaltungsanordnung,
- Figur 2: ein zweites, detailliertes Ausführungsbeispiel einer erfindungsgemäßen Schaltungsanordnung und
- Figur 3: den Verlauf des Miller-Plateaus eines IGBTs bei Ansteuerung mit und ohne erfindungsgemäßer Schaltungsanordnung.

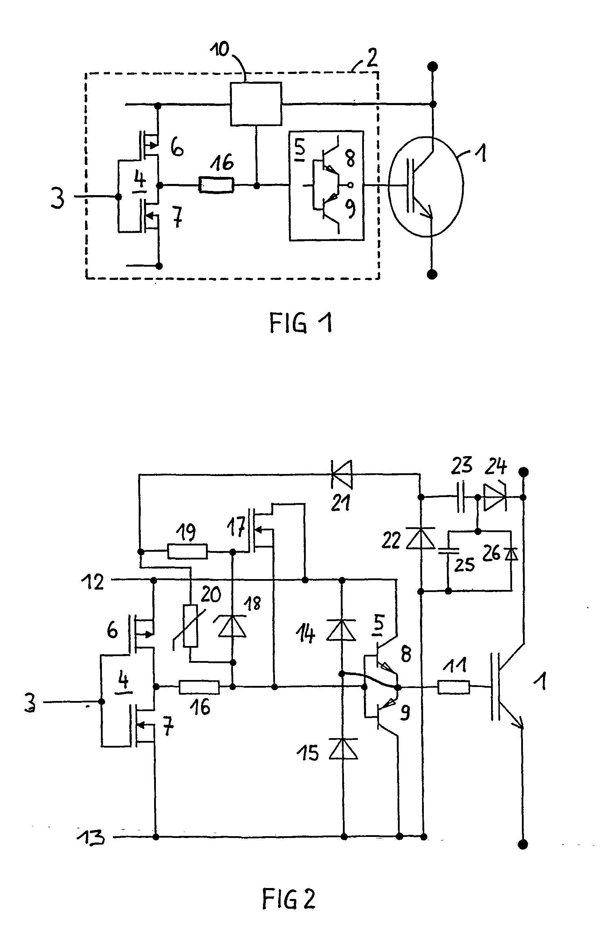

Bei dem in Figur 1 dargestellten Ausführungsbeispiel wird ein Insulated Gate Bipolar Transistor, im Folgenden IGBT 1 genannt, durch eine Ansteuerschaltung 2 in Abhängigkeit von einem Schaltsignal 3 angesteuert. Die Ansteuerschaltung 2 besteht dabei aus zwei Treiberstufen 4 und 5, wobei die Treiberstufe 5 der Treiberstufe 4 über ein Strombegrenzungselement, nämlich einen Widerstand 16, nachgeschaltet ist. Eine Treiberstufe 4 besteht aus einer Gegentakt-Verstärkerstufe mit MOS-Feldeffekttransistoren 6 und 7, während die Treiberstufe 5 einen Gegentakt-Emitterfolger mit zwei Bipolartransistoren 8 und 9 aufweist. Der Ausgang der Treiberstufe 5 ist mit dem Gate des IGBT 1 verschaltet.

Die Ansteuerschaltung 2 weist ferner eine Auswerteeinrichtung 10 auf, die zwischen den Drain-Anschluss des IGBTs 1 und den Knotenpunkt von Treiberstufe 4 und Treiberstufe 5 geschaltet ist.

Die Auswerteschaltung ermittelt die Spannung über der Emitter-Kollektor-Strecke des IGBTs 1, detektiert auf diese Weise den Beginn des Sperrzustandes und friert dann den momentanen Wert des Schaltsignals 3 ein. Es wird eine kleine Stromänderungssteilheit di/dt des Kollektor-Stromes beim Abschalten insbesondere hoher Spannungen erzielt, da der IGBT länger auf dem Spannungsniveau des Miller-Plateaus verharrt.

Eine weiterführende, detaillierte Ausführungsform einer erfindungsgemäßen Schaltungsanordnung ist in Figur 2 dargestellt. Ausgehend von dem Ausführungsbeispiel nach Figur 1 ist dabei wiederum ein IGBT 1 vorgesehen, der über einen Widerstand 11 durch die bereits erläuterte Treiberstufe 5 mit den Transistoren 8 und 9 angesteuert wird. Beim Transistor 8 handelt es sich um einen Bipolartransistor vom NPN-Typ, dessen Emitter und dessen Basis mit Emitter bzw. Basis des Transitors 9 verschaltet sind, der seinerseits durch einen Bipolartransistor vom PNP-Typ gegeben ist. Der Kollektor des Transistors 8 ist an ein positives Versorgungspotential 12 angeschlossen, während der Kollektor des Transistors 9 an ein negatives Versorgungspotential 13 angeschlossen ist. Die miteinander gekoppelten Emitter der Transistoren 8 und 9 sind über jeweils eine Diode 14 bzw. 15 in Sperrrichtung auf das positive Versorgungspotential 12 bzw. das negative Versorgungspotential 13 geführt.

Die miteinander gekoppelten Basen der Transistoren 8 und 9 sind über den Widerstand 16 an den Ausgang der Treiberstufe 4 angeschlossen. Die Treiberstufe 4 umfasst wie beim Ausführungsbeispiel nach Figur 1 zwei MOS-Feldeffekttransistoren 6 und 7, von denen einer (6) vom P-Kanal-Typ ist und der andere (7) vom n-Kanal-Typ ist. Dabei sind Source und Drain des Transistors 6 mit Source bzw. Drain des Transistors 7 verschaltet. Die miteinander gekoppelten Sources bilden dabei den Ausgang der Treiberstufe 4, während die miteinander gekoppelten Gates den Eingang bilden, an den das Schaltsignal 3 angelegt ist.

Die Auswerteschaltung 10 aus Figur 1 wird bei dem Ausführungsbeispiel nach Figur 2 unter anderem durch einen MOS-Feldeffekttransistor 17 vom n-Kanal-Typ gebildet, dessen Source-Anschluss mit den gekoppelten Basen der Transistoren 8 und 9 verschaltet ist und dessen Drain an das positive Versorgungspotential angeschlossen ist. Zwischen das Gate des Transistors 17 und die gekoppelten Basen der Transistoren 8 und 9 ist zudem eine Zenerdiode 18 geschaltet. Das Gate des Transistors 17 ist über einen Widerstand 19 auf einen Knotenpunkt geführt, von dem aus zum einen ein Widerstand 20 auf die gekoppelten Basen der Transistoren 8 und 9 führt und an den zum anderen die Katode einer Diode 21 angeschlossen ist, deren Annode mit einem weiteren Knotenpunkt verbunden ist. An dem weiteren Knotenpunkt ist zum Einen die Katode einer Diode 22 angeschlossen und zum Anderen ein Anschluss eines Kondensators 23. Der andere Anschluss des Kondensators 23 ist über einer Zenerdiode 24 mit dem Kollektor des IGBTs 11 verschaltet. Der Abgriff zwischen Kondensator 23 und Zenerdiode 24 ist über einen Kondensator 25 und einer dazu parallel geschalteten Diode 25 in Sperrrichtung ebenso wie der Annodenanschluss der Diode 22 mit dem negativen Versorgungspotential 13 verschaltet.

Beim Ausführungsbeispiel nach Figur 2 wird mittels des RC-Gliedes mit Kondensator 23 und Widerstand 20 die Zeitkonstante und damit die Stromänderungssteilheit di/dt vorgegeben. Das "Festhalten" des Schaltsignals hält dabei nach dem Spannungsanstieg auf die volle Spannung am Kollektor solange an, bis der Kondensator 23 (Kapazität C₂₃) vollständig umgeladen ist. Der Strom I = C₂₃·dv/dt am Widerstand 20 verlangsamt über den Transistor 17 und die Treiberstufe 5 den Stromabfall im IGBT 1 nach dem Spannungsanstieg.

Die Funktionsweise des Ausführungsbeispiels der Figur 2 beruht dabei auf folgenden Überlegungen. Erhält die Treiberstufe 4 ein Signal mit dem Pegel Null, dann wird der Transistor 7 eingeschaltet und über die Treiberstufe 5 der IGBT 1 abgeschaltet. Mit Erreichen der Schwellenspannung sperrt der IGBT 1 und die Spannung zwischen Emitter und Kollektor des IGBT 1 steigt an. Zu diesem Zeitpunkt ändert sich das entsprechende Potential des Kondensators 23. Ein Strom fließt über den Widerstand 20 zum negativen Versorgungspotential 13. Die am Widerstand 20 abfallende Spannung schaltet den Transistor 17 ein, was sofort einen Stromfluss über den Widerstand 16 zum negativen Versorgungspotential 13 zur Folge hat.

Durch diesen Strom fällt wiederum am Widerstand 16 eine positive Spannung ab, welche direkt über die Treiberstufe 5 den IGBT 1 auf seinem Miller-Plateau hält. Da der Kondensator 23 über den Widerstand 20 entladen wird, ergibt sich folglich eine Zeitkonstante. Innerhalb dieser Zeitkonstante, die die Entladezeit bestimmt, wird die Spannung am Gate des IGBT 1 somit aufrecht erhalten und das Abschalten des IGBTs 1 verlangsamt.

Wird in Reihe zum Kondensator 23 die Zenerdiode 24 geschaltet, wirkt die Auswerteschaltung in Verbindung mit den Treiberstufen 4 und 5 erst bei Überschreiten der Zenerspannung. Um die hohe Sperrschichtkapazität der Zenerdiode 24 zu kompensieren und damit den Einfluss der Schaltung unterhalb der Zenerspannung auszuschalten, ist eine Kompensationskapazität, nämlich der Kondensator 25, von der Anode der Zenerdiode 24 zum negativen Versorgungspotential 13 beziehungsweise auf Masse geschaltet. Um zudem den Kondensator 23 beim Einschalten des IGBTs 1 umzuladen, wird die Diode 22 vorgesehen, wobei die Diode 21 zum Schutz des Transistors 17 und der Zenerdiode 18 vor Verpolung vorgesehen ist. Die Diode 26 schließlich dient zum Entladen des Kondensators 25. Die Dioden 14 und 15 sollen beim Ausführungsbeispiel die beiden Treiberstufen 4 und 5 vor Verpolung und/oder Überspannung schützen.

Führt man schließlich den Widerstand 20 als Potentiometer aus, dann kann die Stärke des Eingriffs eingestellt werden. Darüber hinaus können bei anderen Halbleiterschaltern durch eine einstellbare maximale Stromabschaltsteilheit typenbedingte Unterschiede der Halbleiterschalter im Hinblick auf deren Schaltverhalten ausgeglichen werden.

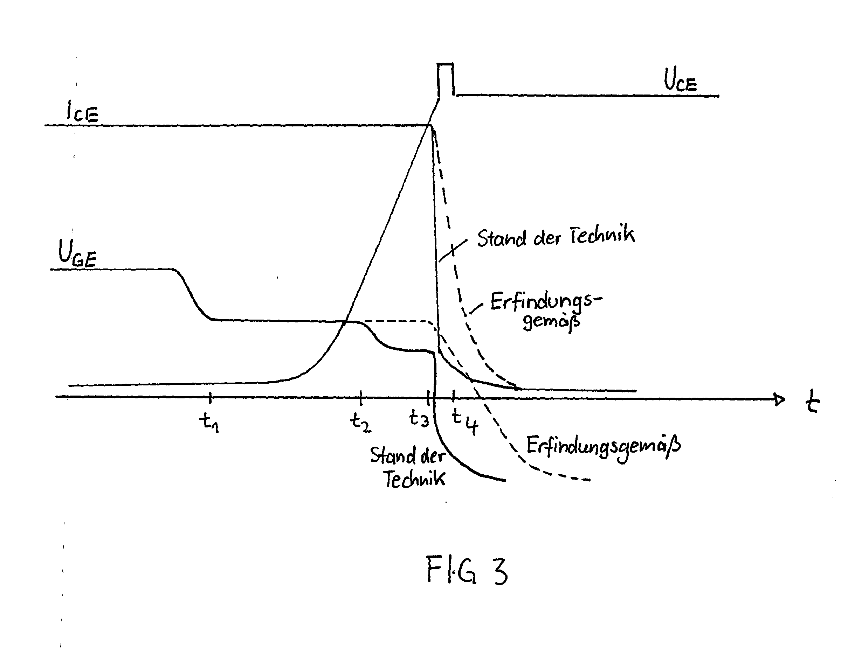

In Figur 3 sind die Verläufe der Kollektor-Emitter-Spannung U_{CE}, des Kollektor-Emitter-Stromes I_{CE} und der Gate-Emitter-Spannung U_{GE} des IGBTs 1 über der Zeit t bei Ansteuerung mit und ohne erfindungsgemäßer Schaltungsanordnung dargestellt. Bei einer bisher üblichen Ansteuerung fällt die Gate-Emitter-Spannung U_{GE} beispielsweise ausgehend von 15 V steil ab bis zum Erreichen des Miller-Plateaus bei etwa 7V (t₁). Hier verharrt die Spannung für einige Zeit bis kurz vor Beginn des Abfalls des Kollektor-Emitter-Stromes I_{CE} (t₂), um dann weiter in zwei Etappen steil auf -15 V abzufallen. Die erste Etappe ist dabei flacher und dauert bis zum eigentlichen Abfall des Kollektor-Emitter-Stromes I_{CE} (t₃). Die daran anschließende Etappe ist steiler und dauert bis zum völligen Absinken der Gate-Emitter-Spannung U_{GE} des IGBTs 1. Einher geht damit ein Anstieg der Kollektor-Emitter-Spannung U_{CE}, der beim Zeitpunkt t₁ beginnt und zum Zeitpunkt t₂ in den Spitzenwert der Kollektor-Emitter-Spannung U_{CE} mündet. Dort bleibt die Kollektor-Emitter-Spannung U_{CE} für kurze Zeit (t₄) und fällt dann auf einen etwas niedrigeren Wert ab, auf dem sie verharrt. Der Kollektor-Emitter-Strom I_{CE} bleibt bis zum Zeitpunkt t₃ konstant und fällt danach steil ab.

Bei erfindungsgemäßer Ansteuerung hingegen bleibt die Gate-Emitter-Spannung U_{GE} hingegen bis zum Zeitpunkt t₃ auf dem Miller-Plateau, also deutlich länger auf dem Miller-Plateau und fällt danach verhältnismäßig flach ab. Auch hier bleibt der Kollektor-Emitter-Strom I_{CE} bis zum Zeitpunkt t₃ konstant, fällt danach jedoch deutlich flacher ab.

### Bezugszeichenliste

- 1: IGBT
- 2: Ansteuerschaltung
- 3: Schaltsignal
- 4: Treiberstufe
- 5: Treiberstufe
- 6: MOS-Transistor
- 7: MOS-Transistor
- 8: Bipolartransistor
- 9: Bipolartransistor
- 10: Auswerteschaltung
- 11: IGBT
- 12: positives Versorgungspotential
- 13: negatives Versorgungspotential
- 14: Diode
- 15: Diode
- 16: Widerstand
- 17: MOS-Transistor
- 18: Zenerdiode
- 19: Widerstand
- 20: Widerstand
- 21: Diode
- 22: Diode
- 23: Kondensator
- 24: Zenerdiode
- 25: Kondensator
- 26: Diode

- t, t₁-t₄: Zeit
- U_{GE}: Gate-Emitter-Spannung
- U_{CE}: Kollektor-Emitter-Spannung
- I_{CE}: Kollektor-Emitter-Strom

## Patentansprüche

1. Schaltungsanordnung zum Ansteuern eines eine gesteuerte Strecke und einen Steueranschluss aufweisenden Halbleiterschalters (1) mit
einem Eingang, an den ein Schaltsignal (3) zur Steuerung des Halbleiterschalters (1) angelegt ist,
einem Ausgang, mit dem der Steueranschluss des Halbleiterschalters (1) gekoppelt ist,
einer zwischen Eingang und Ausgang geschalteten Ansteuerschaltung (2), bei der das Schaltsignal (3) durch ein Haltesignal auf dem augenblicklichen Wert festhaltbar ist, und
einer Auswerteschaltung (10), die eine der Spannung über der gesteuerten Strecke entsprechende Messspannung abgreift und für eine bestimmte Zeitspanne das Haltesignal für die Ansteuerschaltung (2) erzeugt, wenn die Spannung über der gesteuerten Strecke des Halbleiterschalters (1) einen ein Abschalten des Halbleiterschalters (1) signalisierenden Anstieg aufweist, wobei
die Ansteuerschaltung (2) zwei über einen Widerstand (16) hintereinander geschaltete Treiberstufen (4, 5) aufweist und das Haltesignal am Eingang der ausgangsseitigen Treiberstufe (5) eingespeist wird,
zur Einspeisung des Haltesignals ein Regeltransistor (17) vorgesehen ist, dessen gesteuerte Strecke zwischen ein erstes Versorgungspotential (12) und den Eingang der ausgangsseitigen Treiberstufe (5) geschaltet ist und dessen Steueranschluss über ein Koppelnetzwerk (20, 23) mit einem Anschluss der gesteuerten Strecke des Halbleiterschalters (1) gekoppelt ist, so dass der Steueranschluss in Abhängigkeit von der Messspannung derart ausgesteuert wird, dass bei einem von der ersten Treiberstufe (4) erzeugten Signal zum Abschalten des Halbleiterschalters (1) ein Haltesignal erzeugt wird, das diesem Signal entgegenwirkt, wobei das Koppelnetzwerk (20, 23) aufweist:
einen zwischen den Steueranschluss des Regeltransistors (17) und den Eingang der ausgangsseitigen Treiberstufe (5) geschalteten Widerstand (20),
eine Reihenschaltung zweier Dioden (21, 22), wobei die Reihenschaltung der Dioden (21, 22) zwischen den Steueranschluss des Regeltransistors (17) und ein zweites Versorgungspotential (13) geschaltet ist,
einen mit seinem ersten Anschluss an den Mittelabgriff der Reihenschaltung der Dioden (21, 22) angeschlossenen Kondensator (23),
eine zwischen den zweiten Anschluß des Kondensators (23) und den einen Anschluss der gesteuerten Strecke des Halbleiterschalters (1) geschaltete Zenerdiode (24), die die Auswerteschaltung aktiviert, wenn die Spannung über der gesteuerten Strecke des Halbleiterschalters (1) die Zenerspannung übersteigt, sowie
einen Kompensationskondensator (25), der zwischen das zweite Versorgungspotential (13) und den der gesteuerten Strecke des Halbleiterschalters (1) abgewandten Anschluss der Zenerdiode (24) geschaltet ist.

2. Schaltungsanordnung nach Anspruch 1, bei der dem Kompensationskondensator (25) eine Diode (26) parallel geschaltet ist.

3. Schaltungsanordnung nach Anspruch 1 oder 2, bei der als Halbleiterschalter (1) ein Insulated Gate Bipolar Transistor vorgesehen ist.

## Claims

1. Circuit arrangement for controlling a semiconductor switch (1) having a controlled path and a control terminal, comprising
an input at which a switching signal (3) is applied for controlling the semiconductor switch (1),
an output to which the control terminal of the semiconductor switch (1) is coupled,
a control circuit (2) connected between input and output, in which the switching signal (3) can be held at the current value by a hold signal, and
an evaluating circuit (10) which picks up a measurement voltage corresponding to the voltage across the controlled path and generates the hold signal for the control circuit (2) for a particular period of time when the voltage across the controlled path of the semiconductor switch (1) has a rise signalling a turning-off of the semiconductor switch (1), wherein
the control circuit (2) has two driver stages (4, 5) switched in series with one another via a resistor (16) and the hold signal is fed in at the input of the driver stage (5) at the output end,
for feeding in the hold signal, a control transistor (17) is provided the controlled path of which is connected between a first supply potential (12) and the input of the driver stage (5) at the output end, and the control terminal of which is coupled to a terminal of the controlled path of the semiconductor switch (1) via a coupling network (20, 23) so that the control terminal is modulated in dependence on the measurement voltage, in such a manner that in the case of a signal, generated by the first driver stage (4), for turning off the semiconductor switch (1), a hold signal is generated which counteracts this signal, wherein the coupling network (20, 23) exhibits the following:
a resistor (20) connected between the control terminal of the control transistor (17) and the input of the driver stage (5) at the output end,
a series circuit of two diodes (21, 22), wherein the series circuit of the diodes (21, 22) is connected between the control terminal of the control transistor (17) and a second supply potential (13),
a capacitor (23) connected with its first terminal to the centre tap of the series circuit of the diodes (21, 22),
a Zener diode (24), connected between the second terminal of the capacitor (23) and the one terminal of the controlled path of the semiconductor switch (1), which activates the evaluating circuit when the voltage across the controlled path of the semiconductor switch (1) exceeds the Zener voltage, and
a compensation capacitor (25) which is connected between the second supply potential (13) and the terminal of the Zener diode (24) facing away from the controlled path of the semiconductor switch (1).

2. Circuit arrangement according to Claim 1, in which a diode (26) is connected in parallel with the compensation capacitor (25).

3. Circuit arrangement according to Claim 1 or 2, in which an insulated gate bipolar transistor is provided as semiconductor switch (1).

## Revendications

1. Circuit de commande d'un commutateur à semi-conducteur (1) ayant un chemin commandé et un branchement de commande, comprenant :
- une entrée recevant un signal de commutation (3) pour commander le commutateur à semi-conducteur (1),
- une sortie couplée au branchement de commande du commutateur à semi-conducteur (1),
- un circuit de commande (2) branché entre l'entrée et la sortie, et qui permet de maintenir à la valeur instantanée, le signal de commutation (3) par un signal de maintien et
- un circuit d'exploitation (30) qui saisit une tension de mesure correspondant à la tension du chemin commandé et génère pendant une certaine période, le signal de maintien du circuit de commande (2) si la tension du chemin de commande du commutateur à semi-conducteur (1) présente une augmentation signalant la coupure du commutateur à semi-conducteur (1),
circuit dans lequel
le circuit de commande (2) comporte deux étages pilotes (4, 5) branchés l'un derrière l'autre par l'intermédiaire d'une résistance (16) et le signal de maintien est appliqué à l'entrée de l'étage pilote (5) côté sortie,
un transistor de régulation (17) injecte le signal de maintien, transistor dont le chemin commandé est branché entre un premier potentiel d'alimentation (12) et l'entrée de l'étage pilote (5) côté sortie et dont le branchement de commande est relié par l'intermédiaire d'un premier réseau de couplage (20, 23) à un branchement du chemin commandé du commutateur à semi-conducteur (1) de façon que le branchement de commande soit commandé en fonction de la tension de mesure pour qu'avec un premier signal généré par le premier étage pilote (4) pour couper le commutateur à semi-conducteur (1), il génère un signal de maintien qui s'oppose à ce signal et
le réseau de couplage (20, 23) comporte
- une résistance (20) branchée entre le branchement de commande du transistor de régulation (17) et l'entrée de l'étage pilote (5) côté sortie,
- un montage en série de deux diodes (21, 22), ce montage en série ayant les diodes (21, 22) entre le branchement de commande et le transistor de régulation (17) et un second potentiel de référence (13),
- un condensateur (23) branché avec sa première borne à la prise médiane du branchement en série des diodes (21, 22),
- une diode Zener (24) branchée entre la seconde borne du condensateur (23) et l'un des branchements du chemin commandé du commutateur à semi-conducteur (1), cette diode activant le circuit d'exploitation si la tension aux bornes du chemin commandé du commutateur à semi-conducteur (1) dépasse la tension Zener, et
- un condensateur de compensation (25) branché entre le second potentiel d'alimentation (13) et la borne de la diode Zener (24) non tournée vers le chemin commandé du commutateur à semi-conducteur (1).

2. Circuit selon la revendication 1,
**caractérisé en ce qu'**
une diode (26) est branchée en parallèle du condensateur de compensation (25).

3. Circuit selon la revendication 1 ou 2,
selon lequel
le commutateur à semi-conducteur (1) est un transistor bipolaire à porte isolée.
